Europäisches Patentamt

European Patent Office

Office européen des brevets

(11) Numéro de publication: **0 333 603**
A1

# (12) DEMANDE DE BREVET EUROPEEN

(21) Numéro de dépôt: **89420085.6**

(22) Date de dépôt: **08.03.89**

(51) Int. Cl.⁴: **C 30 B 13/34**
C 30 B 29/06

(30) Priorité: **11.03.88 FR 8803756**

(43) Date de publication de la demande:
**20.09.89 Bulletin 89/38**

(84) Etats contractants désignés:
**BE CH DE FR GB IT LI NL**

(71) Demandeur: **ETAT FRANCAIS représenté par le Ministre des PTT (Centre National d'Etudes des Télécommunications)
38-40 rue du Général Leclerc
F-92131 Issy-les-Moulineaux (FR)**

(72) Inventeur: **Dutartre, Didier
4, Allée du Bret
F-38240 Meylan (FR)**

(74) Mandataire: **de Beaumont, Michel
1bis, rue Champollion
F-38000 Grenoble (FR)**

(54) **Procédé de fabrication d'une couche de silicium sur isolant.**

(57) La présente invention prévoit un procédé de recristallisation par fusion de zone d'une couche mince de silicium formée sur un isolant et recouverte d'un encapsulant, comprenant l'étape consistant à effectuer un traitement thermique à une température comprise entre 1250°C et 1400°C avant l'étape de fusion de zone.

EP 0 333 603 A1

# Description

## PROCEDE DE FABRICATION D'UNE COUCHE DE SILICIUM SUR ISOLANT

La présente invention concerne le domaine de la microélectronique, et plus particulièrement le domaine des circuits intégrés fabriqués dans une couche mince de silicium elle-même déposée sur un isolant.

De telles techniques dites de silicium sur isolant sont maintenant connues, et un exemple de procédé de fabrication sur un support isolant d'un film de silicium monocristallin orienté et à défauts localisés est décrit dans le brevet français 2 580 672.

Dans les procédés de fabrication de couches minces, monocristallines, de silicium sur isolant, on dépose par divers moyens une couche mince de silicium sur un substrat isolant, ce substrat étant souvent constitué d'une tranche de silicium revêtue d'oxyde de silicium. Lors de sa formation, la couche de silicium est polycristalline ou amorphe. On cherche donc ensuite à la rendre monocristalline. L'un des procédés les plus couramment adoptés pour ce faire est un procédé de fusion de zone dans lequel on déplace une bande d'énergie amenant la couche mince de silicium près de sa température de fusion, l'orientation cristalline initiale des premiers grains de silicium se propageant normalement tout le long de la tranche. En fait, de nombreux défauts apparaissent et des procédés ont été prévus, par exemple comme cela est décrit dans le brevet susmentionné, pour obtenir une localisation des défauts.

En outre, il a été constaté que, lors des procédés de fusion de zone, la couche mince de silicium avait tendance à se mettre en goutte, en raison du mauvais mouillage de l'oxyde de silicium par le silicium liquide. Le moyen le plus couramment adopté pour réduire l'influence de ce phénomène consiste à revêtir la couche de silicium d'une couche d'un produit encapsulant. Même avec ces couches de produit encapsulant, le phénomène de mise en goutte ne disparaît pas complètement. Il se produit aussi des phénomènes de vides ou d'amincissements localisés de la couche de silicium.

Pour résoudre ces problèmes, on a pensé dans l'art antérieur qu'il convenait de modifier la nature de la couche d'encapsulant. Ainsi, divers types de couches ont été essayés : nitrure de silicium, oxyde de silicium revêtu d'une couche de nitrure, implantation d'azote ou de carbone dans une couche d'oxyde de silicium, etc. Si certains auteurs ont cru voir une amélioration des résultats par l'utilisation de ces diverses techniques, le problème n'a néanmoins pas été totalement résolu et les procédés de fabrication ont été rendus plus complexes avec des risques de pollution de la couche mince de silicium.

Si l'on examine les diverses étapes des procédés connus de fabrication d'une couche mince de silicium, jusqu'à l'étape de recristallisation par fusion de zone, on notera que la plupart de ces étapes qui peuvent être longues sont réalisées simultanément sur des groupes de plaquettes (traitement par lot), et on s'aperçoit qu'aucune de ces étapes antérieures à la fusion de zone n'implique de traitement thermique à très haute température. Par contre, certains documents, tels que le brevet français susmentionné, prévoient un préchauffage dans l'appareil de fusion de zone. D'après l'article de M. Haond, D. Dutartre et D. Bensahel, cette température de préchauffage peut atteindre 1300°C. Ce préchauffage est réalisé tandis que les plaquettes sont placées dans l'appareil de traitement par fusion de zone. Dans cet appareil elles sont inévitablement traitées individuellement et donc leur temps de résidence doit être le plus court possible dans un processus industriel. La fonction du préchauffage est d'éviter que les contraintes thermiques liées au chauffage localisé d'une plaquette selon une bande n'entraînent la rupture de cette plaquette.

Selon la présente invention, il est proposé, avant l'insertion dans l'appareil de fusion de zone, et éventuellement pendant l'étape de formation de la couche d'encapsulant, de procéder à un recuit thermique de longue durée à très haute température de la plaquette sur laquelle est formée la couche mince que l'on voudra ensuite recristalliser.

Par très haute température, on entend ici une température proche de la température de fusion du silicium qui est de 1 410°C. Ainsi, l'invention propose, avant l'étape de recristallisation par fusion de zone, d'effectuer un recuit de longue durée, par exemple de plusieurs heures, à une température de l'ordre de 1250 à 1400°C. Cette température est de préférence voisine de 1350°C.

Il a été constaté que, grâce à cette étape thermique à haute température et en utilisant une simple couche d'encapsulant constituée d'oxyde de silicium, on obtenait après recristallisation une couche monocristalline exempte des défauts susmentionnés, à savoir des amincissements ou des vides.

Ainsi, la présente invention, tout en permettant l'obtention d'un meilleur résultat que les procédés de l'art antérieur, permet d'utiliser des couches d'encapsulant simples, uniquement constituées d'oxyde de silicium, par exemple d'oxyde de silicium thermique.

Un exemple de mise en oeuvre de la présente invention comprend les étapes suivantes :
- partir d'une plaquette de silicium de 100 mm de diamètre ;
- effectuer une oxydation thermique de la plaquette, pour fournir une couche d'oxyde de silicium de 2 µm d'épaisseur ;
- déposer du silicium polycristallin ou amorphe sur une épaisseur de 1,5 micromètres par dépôt chimique en phase vapeur à basse pression ;
- oxyder la couche mince de silicium, pour faire croître par exemple une épaisseur d'environ 2 µm de $SiO_2$ avec une consommation d'environ 1 µm de Si, c'est-à-dire que la couche de Si résiduelle a une épaisseur de 0,5 µm ;
- recuire la structure sous oxygène pendant quatre heures à 1350°C ;
- recristalliser la couche mince de silicium par fusion de zone, par exemple avec une machine à lampe à une vitesse de déplacement de la bande fondue de 0,2 mm par seconde.

L'étape de recuit à haute température selon la présente invention présente l'avantage de pouvoir être effectuée en une fois sur un grand nombre de plaquettes disposées simultanément dans un four. Sa durée présente donc un inconvénient négligeable dans un processus industriel puisque les tranches ne sont pas traitées une par une.

Un autre avantage de la présente invention, réside dans le fait que, comme on le voit à partir de l'exemple ci-dessus, on peut arriver à des couches de silicium très minces ce qui était pratiquement impossible par les techniques de l'art antérieur car les phénomènes de création de vides et d'amincissements susmentionnés sont d'autant plus importants que l'épaisseur de la couche mince de silicium est faible. Les inventeurs ont pu obtenir des tranches sans défauts pour des épaisseurs de la couche mince de 250 à 300 nm alors que, dans l'art antérieur, l'épaisseur minimale si l'on ne voulait pas dépasser un taux de vide de 50/cm² était de l'ordre de 400 à 500 nm avec les mêmes structures et les mêmes techniques de fusion de zone.

Bien qu'aucune explication théorique ne puisse être donnée du résultat obtenu grâce à la présente invention, on peut supposer que le traitement à haute température permet d'améliorer la stabilité du film liquide en diminuant les phénomènes qui déclenchent le démouillage (au front de fusion) et/ou en limitant la propagation de ces démouillages.

## Revendications

1. Procédé de recristallisation par fusion de zone d'une couche mince de silicium formée sur un isolant et recouverte d'un encapsulant, caractérisé en ce qu'il comprend l'étape consistant à effectuer un traitement thermique de longue durée à une température comprise entre 1250°C et 1400°C avant passage dans l'appareil de fusion de zone.

2. Procédé selon la revendication 1, caractérisé en ce que le traitement thermique est réalisé à une température voisine de 1350°C.

3. Procédé selon la revendication 1, caractérisé en ce que le traitement thermique est poursuivi pendant plusieurs heures.

4. Procédé selon la revendication 1, caractérisé en ce que la couche mince à cristalliser est formée sur une tranche de silicium recouverte d'oxyde de silicium et en ce que l'encapsulant est de l'oxyde de silicium.

5. Procédé selon l'une des revendications 1 ou 2, caractérisé en ce que le traitement à haute température se fait en présence d'oxygène.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | MATERIALS LETTERS, vol. 4, no. 1, novembre 1985, pages 13-16, Elsevier Science Publishers B.V. (North-Holland Physics Publishing Division), Amsterdam, Nl; M. HAOND et al.: "Improved heat-sink structure providing single-crystal SOI films prepared by lamp zone melting" * Page 14, paragraphe 2 * --- | 1,2,4 | C 30 B  13/34 C 30 B  29/06 |
| A,D | FR-A-2 580 672  (ETAT FRANCAIS) * Page 17, lignes 21-27; résumé * --- | 1-5 | |
| A | EP-A-0 199 638  (HAOND) * Résumé; colonne 13, lignes 1-17 * ----- | 1-5 | |

**DOMAINES TECHNIQUES RECHERCHES (Int. Cl.4)**

C 23 C
C 30 B

Le présent rapport a été établi pour toutes les revendications

| Lieu de la recherche | Date d'achèvement de la recherche | Examinateur |
|---|---|---|
| LA HAYE | 19-06-1989 | PATTERSON A.M. |

EPO FORM 1503 03.82 (P0402)